# EUROPEAN PATENT SPECIFICATION

(11) **EP 2 672 283 B1**
(45) Date of publication and mention of the grant of the patent: **20.08.2014**
(21) Application number: 12170883.8
(22) Date of filing: 05.06.2012
(51) Int. Cl.: G01R 31/28

(54) **Test device, test system, method and carrier for testing electronic components under variable pressure conditions**
Testvorrichtung, Testsystem, Verfahren und Träger zum Testen von elektronischen Komponenten unter unterschiedlichen Druckbedingungen
Dispositif de test, système de test, procédé et support pour tester des composants électroniques dans des conditions de pression variable

(43) Date of publication of application: 11.12.2013
(73) Proprietor: Multitest elektronische Systeme GmbH, 83026 Rosenheim (DE)
(72) Inventor: Binder, Stefan, 83098 Brannenburg (DE)
(74) Representative: Dilg, Haeusler, Schindelmann Patentanwaltsgesellschaft mbH

(56) References cited:
- EP-A1- 2 015 087
- WO-A2-2009/118101
- US-A- 5 424 634
- US-A1- 2010 206 768
- US-B1- 6 411 111

## Description

### FIELD OF THE INVENTION

The invention relates to a test device for testing an electronic component under variable pressure conditions.
Further, the invention relates to a test system for testing electronic components under variable pressure conditions wherein the test system comprises a plurality of test devices.
Moreover, the invention relates to a method of testing an electronic component under variable pressure conditions.

### BACKGROUND OF THE INVENTION

MEMS microphones are miniaturized microphones used in mobile phones.
MEMS pressure sensors are used to sense pressure in e.g. in tires of cars.
MEMS microphones and pressure sensors are electronic components usually based on semiconductor technology. Fabrication and miniaturization of the
MEMS devices require a reliable test before these electronic components are placed on circuit boards.

Known prior art relating to testing devices and methods for electronic components include: US 5 424 634 A (D1) discloses applying non-destructive cyclical mechanical stress to a component under variable pressure conditions. US 6 411 111 B1 (D2) discloses a testing system comprising an electron beam probe and a photon beam probe for examining a device under test in a controlled pressure environment. EP 2 015 087 A1 (D3) discloses testing of electronic components in a pressure test chamber using an air-tight sealing board. WO 2009/118101 A2 (D4) discloses testing of electronic semiconductor components which convert sound into electrical signals, said semiconductor components being acoustically irradiated in a sound chamber using a piezo element. US 2010/206768 A1 (D5) discloses devices for holding a plurality of singulated semiconductor components, in particular strip carriers and clamping carriers.

### SUMMARY OF THE INVENTION

There may be a need for a reliable test of an electronic component under variable pressure conditions. Also there may be a need to reduce testing costs for the test of an electronic component under variable pressure conditions. Further, there may be a need to have test equipment which allows a flexible adaptation to different test requirements.
In order to achieve these objectives, a test device, a test system and a method for testing electronic components under variable test conditions are provided.

According to an exemplary embodiment of the invention, a test device for testing an electronic component under variable pressure conditions as defined in claim 1 is provided.

The term "test device" may particularly denote something made by arranging technical parts together so that these parts are in a spatial relation and fulfill a specific technical purpose of testing. In particular, test device may be a part of a test system.
The term "electronic component" may particularly denote a so called "DUT" or "device under test". The term "test" or "testing" may particularly denote that a DUT is examined or calibrated. The term "variable pressure conditions" may denote constant air pressure, differential air pressure changes or dynamic air pressure, like sound. The electronic component to be tested (DUT) may be an air or gas pressure sensor for sensing constant pressure or differential pressure. The electronic component may also be a microphone or MEMS microphone for recording or sensing sound. The electronic component may comprise a port for sensing pressure conditions on one side and electrical terminals on the other side. Other electronic components may comprise electrical terminals and the port for sensing pressure conditions both on the same side. "Side" of the electronic component may refer to any plane of the electronic component. In particular, a side of the electronic component may denote a main plane of the electronic component. The expression "main plane" of the electronic component may refer to the side of the largest extension among the sides of the electronic component.
The term "chamber" may particularly denote something that encloses space or a cavity. The term "chamber half" may particularly denote that there are at least two parts forming the chamber. The complete interior of the chamber may be called "cavity". In particular, with use of the chamber variable pressure conditions are generated in the cavity enclosed by the chamber. Each of the chamber halves may be airtight depending on a given air pressure. Air pressure conditions in the chamber may vary from 20 kPa to 250 kPa.
The term "airtight seal" may particularly denote a measure to prevent the passage of gas or air out of a chamber or a return of gas or air into the chamber. The term "seal" may express the effect resulting by tightly abutting parts. Thus, the term "airtight seal" may denote the functionality that there is a tight and perfect closure against the passage of gas or air between two abutting parts.
The terms "first gasket" and/or the "second gasket" may denote elements intended to seal. A sealing may be realized by a separate device, e.g. a closed sealing ring or a gasket plate. The sealing ring or the gasket plate may be made from a smooth material, e.g. rubber or other plastic material. The first gasket and the second gasket may fit between two parts, e.g. between the first chamber half and the second chamber half, in order to generate an airtight seal. Under regular operating conditions the airtight seal may be opened without damaging the first gasket, the second gasket or any part of the test device.
The term "carrier" may particularly denote a clamping carrier or a so called strip or strip device. The carrier may be adapted to carry a plurality of electronic components or DUTs so that the DUTs are mutually transportable and aligned on the carrier. The carrier may be flat in relation to the length and width. The longest length and width of the carrier sides may define the main plane of the carrier. While electronic components are aligned on the carrier a test routine may run in order to test or calibrate the electronic components. A handler may handle the electronic components and may generate the required pressure conditions. A so called tester (a computer) may be used to perform the electronic test. The handler and the tester may together be called "ATE" or "automated test equipment".
The term "carrier segment" may particularly denote a part or region of the carrier extending in the main plane of the carrier. In particular, the carrier segment may be given by a partial area of the carrier. The term "to surround" may particularly denote to circle or to close in a ring wherein the ring may have a regular or an irregular and non-symmetric shape.
The term "circular carrier section" may particularly denote a part or a region of the carrier which may be geometrically defined by a closed line having a non neglectable width. In particular, the circular carrier section having a certain width may enclose the carrier segment. Thus, the circular carrier section may form a boundary of the carrier segment. A subgroup of a plurality of electronic components may denote a group of one, two, three, four or more electronic components wherein the number of electronic components of the subgroup may be smaller than the number of the plurality of electronic components placed on a completely assembled carrier. In particular, the subgroup of the plurality of the electronic components may comprise two, three, four or more electronic components. The circular carrier section and the carrier segment may denote two different parts of a one-piece carrier. The use of the expressions "circular carrier section" and "carrier segment" may emphasize different functional purposes even if the circular carrier section and the carrier segment are integrally formed from the carrier. The term "integrally formed" may denote that the carrier is a one-piece part or a continuous piece.
The term "side of the circular carrier section" may particularly denote a surface being parallel to the main plane of the carrier. The "first side" may be the surface of the circular carrier section which faces towards the first chamber half, and the second side may be the surface of the circular carrier section which faces towards the second chamber half.
In particular, a "side of the circular carrier section" may denote that it encloses the geometric shape of the carrier segment. The circular carrier section may have an overlap with the first and/or second gasket.
The term "airtight seal" may particularly denote a joint or contact between two parts by means of a gasket wherein the joint is impermeable or nearly impermeable to air or gas. Airtightness or impermeability may depend on the pressure being applied in the cavity.

A gist of the test device may be to provide a chamber for testing electronic components being smaller than a chamber which encloses a complete carrier. Thus, the carrier segment and the surrounding circular carrier section are functional parts of the test device. In particular, the segment and the surrounding circular carrier section are sealing parts of the chamber comprising the first chamber half and the second chamber half.
A reduced chamber size may have a positive effect when sealing the chamber is required. Tolerances or deviations of abutting chamber halves may be easier to handle when the chamber size is small. The circular carrier section surrounding the carrier segment may be used for sealing purposes and as an intermediate part of the test device. Consequently, there is no need to enlarge the chamber to the size of a regular carrier or strip and on the other hand there is no need to minimize the carrier or strip size. The quality of the sealing and/or airtightness may depend on the force which presses the chamber halves against the circular carrier section being covered by gaskets on both sides. The circular carrier section and the first gasket may overlap along the complete length of the circular carrier section. Also, the circular carrier section and the second gasket may overlap along the complete length of the circular carrier section.
The chamber may comprise the first chamber half, a first gasket, a circular carrier section, a second gasket and a second chamber half. The first chamber half may abut to the first gasket, the first gasket may further abut to the first side the circular carrier section, the second side of the circular carrier section may abut to the second gasket and the second gasket may further abut to the second chamber half. The first cavity half may be enclosed by the first chamber half and a first carrier segment side. The second cavity half may be enclosed by the second chamber half and a second carrier segment side.
The cavity may be built up by the first cavity half and the second cavity half lying on opposite sides of the carrier segment. The carrier segment carrying a subgroup of the electronic components may be located inside the cavity between the first chamber half and the second chamber half. An electrical test of the electronic components under variable pressure conditions may be more reliable when the electronic components are already aligned on the carrier segment. Further the carrier segment may support the contact force for contacting the electronic components with contact springs of a test socket. In particular, the size of the cavity comprising the first cavity half and the second cavity half may be minimized when doing sound test. In particular, the cavity may have a maximum free length being smaller than the half of the wavelength relating to a maximum test frequency. The maximum test frequency may be 20 kHz, so that the half of the wavelength may be 0,86 cm at ambient temperature. In particular, the maximum test frequency may be 12 kHz, so that the half of the wavelength may be 1,4 cm at ambient temperature. In particular, the maximum test frequency may be 8,0 kHz, so that the half of the wavelength may be 2,1 cm at ambient temperature. In particular, the maximum test frequency may be 5,0 kHz, so that the half of the wavelength may be 3,4 cm at ambient temperature. In particular, the maximum test frequency may be 2,0 kHz, so that the half of the wavelength may be 8,6 cm at ambient temperature. In particular, the maximum test frequency may be 1,0 kHz, so that the half of the wavelength may be 17,2 cm at ambient temperature. In particular, the maximum test frequency may be 0,50 kHz, so that the half of the wavelength may be 34,4 cm at ambient temperature. The term "maximum free length" may denote a longest and straight line in the cavity enclosed by the chamber. Disturbing effects like resonance and distortion may be reduced so that the frequency response of the chamber may be optimized. A test result may be more reliable for high test frequencies having short wavelengths and high tone pitches.

According to another embodiment of the invention, a test system for testing electronic components under variable pressure conditions is provided wherein the test system comprises a plurality of test devices having the described features.

The term "test system" may comprise two or more of the test devices. The test system may comprise a plurality of test devices being arranged in matrix form. In particular, the test system may comprise the complete carrier so that each carrier segment is enclosed by the first and the second chamber half. The number of carrier segments then may be equal to the number of chambers. If testing of the whole carrier is not possible in one test cycle the electrical signals may be multiplexed. As an alternative the carrier may be shifted in relation to the first chamber halves and the second chamber halves so that only portions of the carrier are enclosed in the cavities. According to this, only few chambers may be necessary to test all carrier segments of the carrier.

According to a further embodiment of the invention a method of testing an electronic component under variable pressure conditions as defined in claim 12 is provided.

The carrier segment may be used for aligning and supporting the electronic components and for building up an airtight sealing between the first chamber half and the second chamber half. Any features applying to the test device and the test system may also apply to the method. In particular, the method of doing sound test may comprise a cavity having a size so that the maximum free length within the chamber defining the cavity may be smaller than the half of the wavelength relating to a maximum test frequency.

An example useful for understanding the invention is a carrier for testing an electronic component under variable pressure conditions wherein the carrier comprises:
a carrier segment and a circular carrier section comprising a first side and a second side, wherein the circular carrier section surrounds the carrier segment,
wherein the carrier segment is adapted to carry a subgroup of the plurality of the electronic components,
wherein the first side of the circular carrier section is adapted to form an airtight seal with a first chamber half when placing a first gasket between the first chamber half and the first side of the circular carrier section and wherein the second side of the circular carrier section is adapted to form an airtight seal with a second chamber half by placing a second gasket between the second chamber half and the second side of the circular carrier section.

Carriers of the described form may be specified strips or clamping carriers. The size of strips and clamping carriers may already been given by established processes in the semiconductor industry. When dividing the carrier into carrier segments the flexibility of the test system may rise. The size of the carrier segments may be adapted to the required pressure conditions. Additionally, the size of the strips or clamping carriers may remain unchanged which reduces test costs.

In the following, further embodiments of the test device will be described. However, these embodiments also apply to the test system, the method and the carrier for testing electronic components under variable pressure conditions.

The test device may further comprise a through hole through the carrier segment, wherein the through hole functions as a bidirectional passage for gas flow between a first cavity half and a second cavity half.

The through hole may enable passing of air or gas between the first cavity half and the second cavity half. So, same pressure conditions may be on both sides of the carrier segment. The electronic device may comprise a port on one side and its terminals on another side. Also, there are electronic components having ports and electrical terminals on same sides. The through hole may allow for testing of any electronic component no matter if the ports and terminals are located on same or different sides of the electronic component (usually called "port up" and "port down"). Static and/or dynamic pressure conditions may be generated almost simultaneously on both sides of the electronic component. So, the through hole may provide pressure-balancing between the first chamber half and the second chamber half. In particular, the through hole may be located in the middle of the test device or equidistant to every electronic component positioned on the carrier segment. The test device comprising a through hole through the carrier segment allows a test of electronic components which are "port up" or "port down".

The test device may be provided wherein the circular carrier section is an airtight wall section of the carrier.

The circular carrier section may form an airtight wall section between the first gasket and the second gasket. The circular carrier section may be positioned between the first gasket and the second gasket. In particular, the circular carrier section and an area of the first or second gasket may overlap along the full length of the circular carrier section. The circular carrier section may be an airtight wall section along the full length of the circular carrier section.
Each chamber part should be airtight if airtightness of the complete device is required. In particular, the section of the carrier being a part of the chamber may be airtight. The carrier may comprise continuous material along the length of the circular carrier section. The continuous material may be a solid material not being interrupted along the length of the circular carrier section. However, the carrier may comprise a sequence of layers and the wall-section of the circular carrier section may also comprise the sequence of layers being airtight. However, the sequence of the layers may comprise a plurality of plates being continuous along the circular carrier section.

The test device may further comprise a test socket adapted to make electrical contact to terminals of the electronic component.

Test sockets, well known in the field of automated test equipment (ATE), are adapted to connect pads or terminals of an electronic component to a tester. The test socket may comprise contact springs to make electrical contact to the terminals of the electronic components. The force for contacting an electronic component with a contact spring of the test socket may require a force which may be multiplied by the number of terminals of the DUT and still may be multiplied by the number of DUTs located on the carrier segment. The test socket may be covered by a socket cover. A board O-ring may be situated between the socket cover and the DUT board to generate an airtight seal. So, the board O-ring may generate an airtight seal between the test socket and the DUT board.

The test device may further comprise a membrane for generating a sound output.

The membrane may be an integrally part of the first chamber half or the second chamber half and may work as a loudspeaker. The term "sound output" may particularly, denote a single tone, a complex tone or a complex tonal sound. The sound output may be generated by a piezo-stack moving the membrane. The subgroup of the electronic components to be tested by the test device may comprise one, two, three, four or even more electronic components. In particular, every electronic component of the electronic components to be tested may be positioned equidistant to the membrane generating the sound output. The carrier segment may be adapted to provide positions of the electronic components being equidistant to the position of the membrane or the center of the membrane.

The test device may further comprise a reference microphone for determining a value of an input sound.

The reference microphone may be an integrally part of the first chamber half wherein the membrane may be positioned on the second chamber half. In particular, the reference microphone may be positioned opposite of the membrane. In particular, the reference microphone and the electronic components may be positioned equidistant to the membrane. So, the input sound detected by the reference microphone may serve as reference for the sound test.

The test device may further comprise an inlet being connected to a pressure generator.

An air pressure generator may apply air pressure in the chamber via a pressure line and an inlet. Due to the reduced size of the test device the mechanical work for applying a required pressure in the chamber is as small as the pump volume.

The test device may be provided wherein the carrier is a strip comprising a substrate and wherein the substrate forms the circular carrier section and the carrier segment.

So called "strips" are well-known in the semiconductor industry. Strips may comprise a substrate and electronic components being aligned on the substrate. The substrate may be structured so that the circular carrier section surrounding the carrier segment abuts with the first chamber half on one side and with the second chamber half on the other side. When placing a sealing ring or a gasket plate between the circular carrier section and one of the chamber halves an airtight coupling may be produced between the circular carrier section and the chamber halves. The substrate may be unbroken along the circular carrier section so that the airtight wall section is formed by the substrate.

The test device may be provided wherein the carrier is a clamping carrier comprising multiple layers and wherein the clamping carrier forms the circular carrier section and the carrier segment.

A clamping carrier may comprise a plurality of metal layers in order to carry and align a plurality of semiconductor devices. The clamping carrier may comprise springs formed from a spring plate or a spring layer so that the semiconductor devices can be clamped and aligned on the clamping carrier. The layers of the clamping carrier may be structured and put together so that the airtight wall section is formed along the circular carrier section. A top layer of the clamping carrier may be a receiving plate abutting to the first gasket. The layer below the receiving plate may be the spring plate comprising the springs for clamping the electronic components. A bottom layer may be a base plate so that the springs of the spring plate may be guided between the base plate and the receiving plate. The shape of the circular carrier section may be irregular. The airtight wall section may be formed by unbroken layers along the length of the circular carrier section.

In the following, further embodiments of the test system will be described. However, these embodiments also apply to the test device, the method and the carrier for testing electronic components under variable pressure conditions.

The test system may comprise two groups of first gaskets and second gaskets wherein at least one of the groups is integrally formed from one gasket plate.

A group of first gaskets may be integrally formed by one gasket plate on top of the carrier segments. A group of second gaskets may be integrally formed by one gasket plate below the carrier segments.

It may be appropriate to use one gasket plate extending on the area of the complete carrier. In particular, the gasket plate may have the size of the carrier and may have openings arranged in matrix-form. Each one of the openings of the gasket plate may match with one of the carrier segments so that an airtight sealing is formed between the carrier segments by the circular carrier sections and the abutting chamber halves. In particular, one gasket plate is used for the first chamber half and another gasket plate is used for the second chamber half.

The test system may further comprise a pressing device wherein the pressing device is adapted to press a board unit and a pressure unit against each other. The board unit may comprise the first chamber half and a DUT board. The pressure unit may comprise the second chamber half. In particular, the pressing device may exert a pressing force which generates the airtight seal between the circular carrier section and the chamber halves. The force of the pressing device may also exert contact pressure on the first chamber half and the second chamber half, so that the intermediate first gaskets and second gaskets generate the airtight seal. In particular, the first gasket plate and the second gasket plate may comprise thicknesses so that the pressing force exerted by the pressing device automatically generates the airtight seal and the contacting force. The term "contacting force" may be the force to make electrical contact between the terminals of the electronic devices and the springs of the contact sockets.

In the following, further examples of the carrier will be described. However, these examples also apply to the test device, the test system and the method of testing electronic components under variable pressure conditions.

The carrier may be provided wherein the circular carrier section is an airtight wall section.

The airtight wall section may be formed from a continuous material. The continuous material may be continuous along the circular carrier section. However, the continuous material may comprise layers being continuous along the circular carrier section. So, the carrier may comprise one or more layers wherein each layer is continuous along the circular carrier section. The carrier segment of the carrier may comprise a through hole wherein the through hole forms a bidirectional passage for gas flow.

### BRIEF DESCRIPTION OF THE DRAWINGS

These and other characteristics of the invention will be clear from the following description of embodiments, given as non-restrictive examples, with reference to the attached drawings wherein:
Fig. 1 shows an exploded view of a test system;
Fig. 2 shows a perspective view of a cross-section of a test system;
Fig. 3 shows a cross-sectional view of a stimulus section and a test device;
Fig. 4 shows a cross-sectional view of a test device based on a clamping carrier;
Fig. 5 shows a cross-sectional view of a test device based on a strip;
Fig. 6 shows a carrier;
Fig. 7 shows a detail of a clamping carrier;
Fig. 8 shows a further detail of a clamping carrier with a visible spring plate;
Fig. 9 shows a detail of a test device in a cross-sectional view.

### DESCRIPTION OF EMBODIMENTS

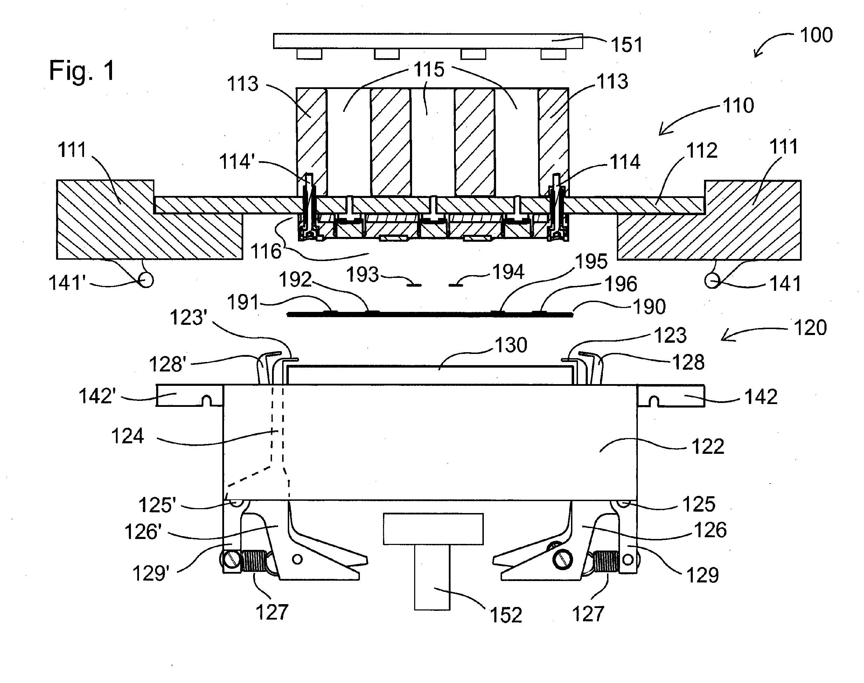

Figure 1 shows a test system 100 comprising a board unit 110 and a pressure unit 120. The test system 100 may further comprise a pressing block 151 and support device 152 acting as a pressing device 151, 152 so that the board unit 110 and the pressure unit 120 are pressed against each other to provide airtightness in between for a chamber. Alternatively, a board frame 111 which is a stiffening part of the board unit 110 may comprise clamping yokes 141, 141'. Further, the stimulus block 120 may comprise support arms 142, 142'. The clamping yokes 141, 141' may engage with the support arms 142, 142' so that the board unit 110 and the pressure unit 120 are pressed against each other. The clamping yokes 141, 141' and the support arms 142, 142' may together also be called "pressing device" 141, 142.

Before pressing the board unit 110 and the pressure unit 120 against each other the pressure unit 120 may clamp a carrier 190. A plurality of electronic components 191, 192, 193, 194, 195 and 196 are aligned on the carrier 190. In order to fix the carrier on a stimulus block 130 open clamping brackets 128, 128' may close so that closed clamping brackets 123, 123' fix the carrier 190 on the stimulus block 130. The clamping brackets 123, 123', 128, 128' may extend at the end of levers 124. Each lever 124 may have an axis 125, 125' as suspension. Springs 127, 127' may be fixed on spring suspensions 129, 129' and on spring arms 126, 126' extending opposite to the levers 124. The axis 125, 125' may be in the middle of the spring arms 126, 126' and the levers 124. The springs 127, 127' may be biased so that an automatic turning of the spring arms 126, 126' closes the clamping brackets 123, 123'. So, the carrier 190 is clamped on the stimulus block 130. The stimulus block 130 may be integrated in a block holder 122. The support arms 142, 142' may be fixed on the block holder 122 and the axis 125, 125' may be suspended on the block holder 122.

A DUT board 112 may be fixed on a board frame 111 of the board unit 110. A stiffener 113 comprising drill-holes 115 to reduce mass may support the DUT board 112 in the region of a socket unit 116. The socket unit may be fixed on the DUT board 112 by pins 114, 114'.

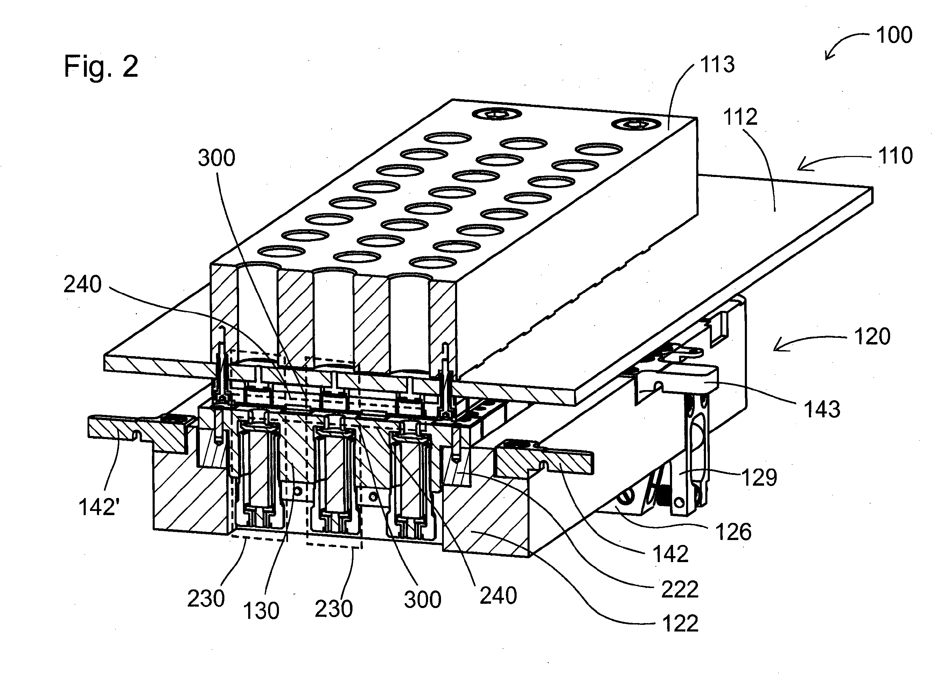

Figure 2 shows a perspective view of the test system 100 similar to the test system shown in figure 1. The pressure unit 120 comprises the block holder 122 and a connecting frame 222 in the center of the block holder 122. The stimulus block 130 which carries stimulus sections 230 is fixed to the connecting frame 222 in the center of the pressure unit 120. The pressure unit 120 comprises the vertical stimulus sections 230 and a horizontal chamber section 240. A test device 100 may be a cross section of the respective stimulus section 230 and the chamber section 240.

Support arms 142, 142' may be fixed on opposite length sides of the pressure unit 120. A further support arm 143 may be fixed apart of the support arm 142 on the length side of the pressure unit 120.

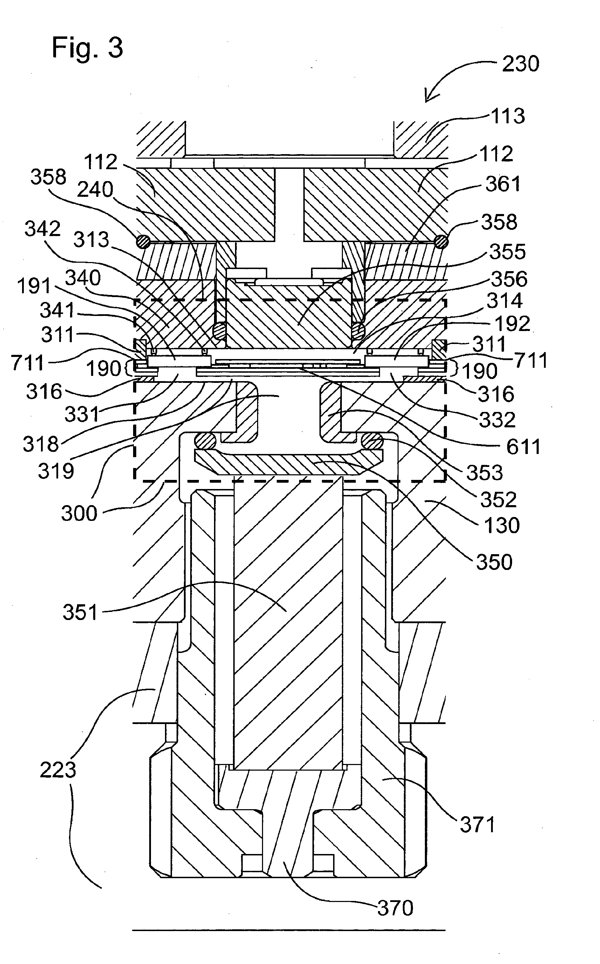

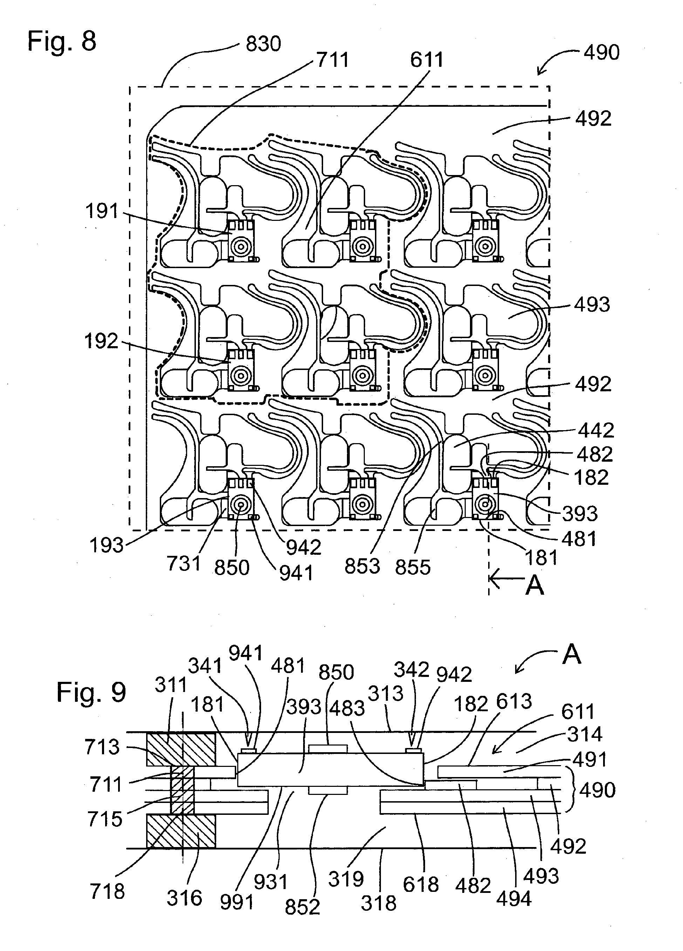

Figure 3 shows a cross-sectional view of a test device 300. The test device 300 comprises a first chamber half 313, a second chamber half 318, a carrier segment 611 and a circular carrier section 711. The carrier segment 611 is located between the first chamber half 313 and the second chamber half 318. The circular carrier section 711 surrounds the carrier segment 611 and delimits the test device 300. A first gasket 311 is located between the first chamber half 313 and the circular carrier section 711 on one side to generate an airtight seal between the first chamber half 313 and the circular carrier section 711. A second gasket 316 is located between the second chamber half 318 and the other side of the circular carrier section 711 to generate an airtight seal between the second chamber half 318 and the circular carrier section 711. The space between the first chamber half 313 and the carrier segment 611 may be called "first cavity half" 314. And the space between the second chamber half 318 and the carrier segment 611 may be called "second cavity half" 319. The carrier segment 611 extends parallel to the chamber section 240 and through the stimulus section 230. Thus, the test device 300 is a cross-section of the chamber section 240 and the stimulus section 230. The first electronic component 191 and the second electronic component 192 are located on the carrier segment 611. The test device 300 may further comprise a test socket 340 comprising spring contacts 341, 342 adapted to make electrical contact to terminals 941, 942 of the electronic component 191 (see also Fig. 9). Identical reference signs are used in the same meaning in the drawings and throughout the description of the drawings. Repetitions of already explained details may therefore be omitted.

Figure 3 further shows that the carrier segment 611 comprises a first through hole 331 below the first electronic component 191 and a second through hole 332 below the second electronic component 192. The first cavity half 314 and the second cavity half 319 are connected by the first through hole 331 and the second through hole 332 so that air flow or gas flow between the first cavity half 314 and the second cavity half 319 is possible. The carrier segment 611 may be a part of the carrier 190 and may extend in the area inside the circular carrier section 711.

The test device 300 may further comprise a membrane 350 partially forming a boundary of the second cavity half 319. A piezo stack 351 may induce vibrations of the membrane 350 so that the membrane 350 may generate sound output. A movable end of the piezo stack 351 may abut on the membrane 350. The piezo stack 351 may be mounted to a piezo holder 371. The piezo stack 351 may extend through a block support 223 and into the stimulus block 130. The piezo stack 351 may be electrically coupled to a power supply terminal 370. The membrane 350 may be a thin and lighthweight metal plate which is coupled to the second cavity half 319 by an O-ring 352. The coupling by the O-ring 352 may be airtight and may allow forth and back movement of the membrane 350 generating sound output induced by the piezo stack 351. A sleeve 353 may be used for stabilization and to alter the shape and size of the second cavity half 319.

Further, the test device 300 may comprise a reference microphone 355 which forms a partial boundary of the first cavity half 314. An O-ring 356 around the reference microphone 355 may hold the reference microphone 356 and may generate airtightness. The DUT board 112 may be used to make electrical contact between the electrical components 191, 192 or DUTs and a tester. A socket cover 361 may be mounted on the test socket 340 which may be adapted to make electrical contact with a DUT board 112 being used to electrically couple to the tester of the ATE (automated test equipment). A board O-ring 358 may be placed between the socket cover 361 and the DUT board 112 in order to generate an airtight seal. The DUT board 112 may be mounted on the stiffener 113.

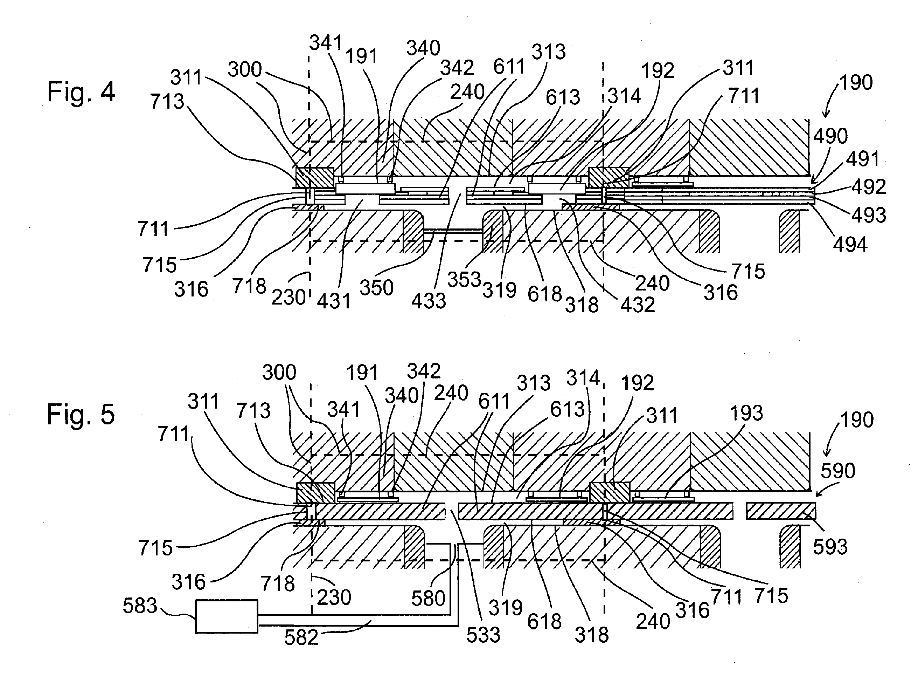

Figures 4 and 5 show that the circular carrier section 711 comprises a first side 713 abutting to the first gasket 311 and a second side 718 abutting to the second gasket 316. The carrier segment 611 comprises the afore mentioned through holes 331, 332 and in addition a central through hole 433 in the middle of the carrier segment 611. The electronic components 191 and 192 may be positioned equidistant to the membrane 350.

Further, figure 4 and 5 show that the circular carrier section 711 forms an airtight wall section 715 surrounding the carrier segment 611. The carrier may be of continuous material along the circular carrier section 711 so that the wall section 715 generates airtightness.

According to figure 4, the carrier 190 (see Fig. 1) may be a clamping carrier 490 comprising four layers: a receiving plate 491, a spring plate 492, an intermediate plate 493 and a base plate 494. The first side 613 of the carrier segment 611 may face towards the first chamber half 313 and towards first cavity half 314. The receiving plate 491 may form a large area of the first side 613 of the carrier segment 611. A second side 618 of the carrier segment 611 may face towards the second chamber half 318 and towards the second cavity half 319. The base plate 494 may form a large area of the second side 618 of the carrier segment 611. Functionalities of the clamping carrier 490 are described more detailed in figures 8 and 9.

According to figure 5, the carrier 190 (see Fig. 1) is a strip 590 comprising a substrate 593. Electronic components 191, 192 and 193 may be placed on the substrate 593. A central through hole 533 may extend through the substrate 593 and couples the first cavity half 314 and the second cavity half 319. The test device 300 may comprise an inlet 580 being coupled to a pressure generator 583 via a pressure line 582. The substrate 593 may form the airtight wall section 715. Other features are identical or equal to the features mentioned in the description of figure 4.

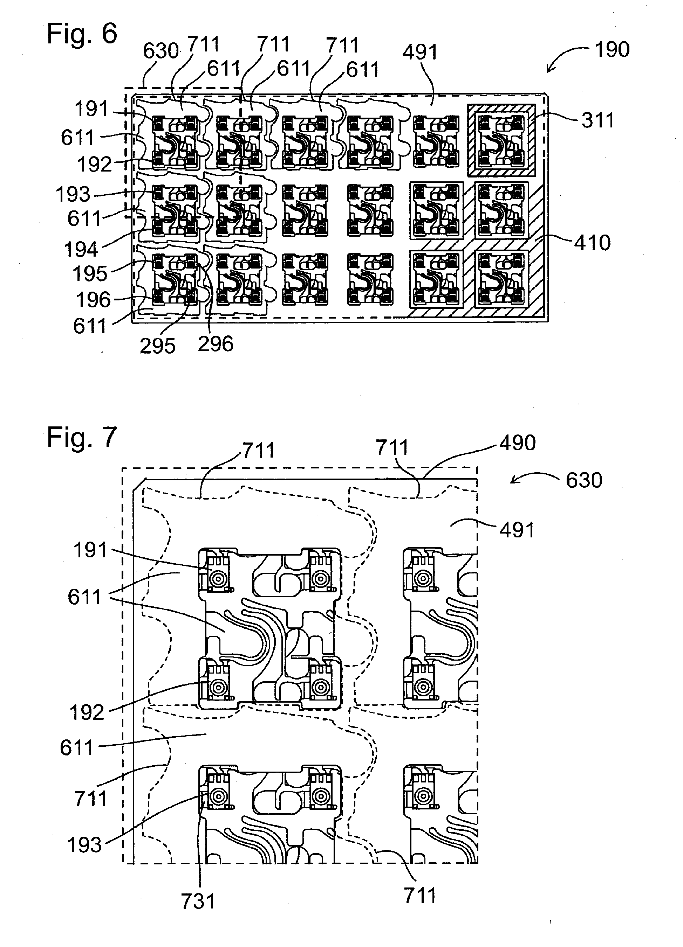

Figure 6 shows a carrier 190 and a first gasket 311 which is placed on the carrier 190. The first gasket 311 may have the form of a sealing ring surrounding the carrier segment 611. Alternatively, a plurality of first gaskets 311 arranged in matrix form may be equivalent to the use of a gasket plate 410 covering the complete carrier 190 and having openings in the area of the carrier segments 611. The carrier 190 may comprise a plurality of carrier segments 611 being arranged in rows and columns. On each carrier segment 611 four electronic components 195, 196, 295, 296 may be clamped so that the electronic components are arranged in columns 191, 192, 193, 194, 195, 196 and rows 195, 295 as well. A receiving plate 491 may be the top layer of the carrier 190 so that the first gaskets 311 or the gasket plate 410 may cover the receiving plate 491.

A detail 630 of the carrier 190 depicted with a dashed line in figure 6 is shown more detailed in figure 7. The carrier 190 shown in figure 7 may be a clamping carrier 490 having the receiving layer 491 on top. Each circular carrier section 711 may delimit the respective carrier segment 611. The circular carrier section 711 may have a non-regular shape. In regions where the circular carrier sections 711 come closer to one another each layer of the carrier 190 may be made of continuous material so that the carrier segments 611 are separated from each other. Additionally, every carrier segment 611 may be surrounded by one circular carrier section 711 wherein each of the circular carrier sections 711 may form an airtight wall section 715 (compare Figs. 4, 5 and 9). Each of the circular carrier sections 711 may have an identical shape being irregular when a high areal density for the electronic components 191, 192, 193, 194 is required. Near each of the electronic components 191, 192, 193, 194 there may be a through hole 731 which allows air passage between the two main planes of the carrier 190.

In figure 8 a further detail 830 of the carrier 190 is enlarged compared to the detail 630 of figure 6 and 7. The top layer of the clamping carrier 490 shown in figure 8 is the spring plate 492. The spring plate 492 may comprise a plurality of springs 853. Each spring 853 may have an actuatable element 855 at the free end. In the direction of a movement of the spring 553 may be a nose 482 comprising an abutting section 483. Every spring 853 of the spring plate 492 may need a certain movement space which may delimit the width of the airtight wall section 715. However, the circulate carrier section 711 may have a certain width so that airtightness is generated by the wall section 715.

A first abutting side 181 of the electronic component 393 may abut on a first edge 481 of the clamping carrier 490 and a second abutting side 182 of the electronic component 393 may be pressed together by the nose 482. So the electronic component may be aligned on the clamping carrier. An intermediate plate 493 may be the next layer below the spring plate 492. Alternatively, a base plate 494 may be the undermost plate (see Fig. 9). Any of the electronic components 193 may comprise a port 850 for sensing pressure or sound and any of the electronic components 393 may comprise terminals 941, 942 on top.

A partial cross section A indicated in Fig.8 is shown in Fig. 9. The first abutting side 181 and the second abutting side 182 are opposite sides of the body 991 of the electronic component 393. Abutting section 483 of nose 482 abuts on the second abutting side 182. So the electronic component 393 is pressed towards the edge 481 with the first abutting side 181. So, the pressing force exerted by the nose 482 clamps the electronic component 393 between the abutting section 483 and the edge 481 of the clamping carrier 490. The edge 481 abuts on the first abutting side 181and the abutting section 483 abuts on the second abutting side 182 so that the electronic component 393 is aligned on the clamping carrier 490 to the fixed edge 481.

A port 850 may be on the identical side of the main plane of the body 991 like the first terminal 941 and the second terminal 942. The first terminal 941 and the second terminal 942 may be contacted by spring contacts 341 and 342 of the contact socket 340 (see also Fig. 3 or 4). Alternatively, a port 852 may be located on the other main plane of the body 991 and opposite of the first terminal 941 and the second terminal 942. The trough hole 931 may extend below the electronic component 393.

Between the first gasket 311 and the second gasket 316 and along the circular carrier section 711 the clamping carrier 490 may have a layer structure comprising the receiving plate 491, the spring plate 492, the intermediate plate 493 and the base plate 494. The airtight wall section 715 is shown as hatched area to emphasize that the clamping carrier 490 comprises continuous material forming the airtight wall section 715 even when the clamping carrier 490 has a layer structure comprising the mentioned plates (491, 492, 493, 494).

## Claims

1. A test device (300) for testing an electronic component (191) under variable pressure conditions, comprising:
a first chamber half (313) and a second chamber half (318),
a first gasket (311) and a second gasket (316),
a carrier (190) adapted to carry a plurality of electronic components,
wherein the carrier (190) comprises a carrier segment (611) and
a circular carrier section (711),
wherein the circular carrier section (711) denotes a region of the carrier which is defined by a closed line having a non neglectable width,
wherein the circular carrier section (711) surrounds the carrier segment (611) and wherein the carrier segment (611) is adapted to carry a subgroup of the plurality of the electronic components,
wherein the circular carrier section (711) comprises a first side (713) and a second side (718),
wherein the first gasket (311) is placed between the first chamber half (313) and the first side (713) of the circular carrier section (711) to form an airtight seal and
wherein the second gasket (316) is placed between the second chamber half (318) and the second side (718) of the circular carrier section (711) to form an airtight seal;
**characterised in that**, said test device comprising
a membrane (350) for generating a sound output.

2. The test device (300) according to claim 1, further comprising a through hole (331, 332, 431, 432, 433, 533, 731, 931) through the carrier segment (611),
wherein the through hole functions as a bidirectional passage for gas flow between a first cavity half (314) and a second cavity half (319).

3. The test device (300) according to claim 1 or 2, wherein the circular carrier section (711) is an airtight wall section (715) of the carrier (190).

4. The test device (300) according to any one of the claims 1 to 3, further comprising a test socket (340) adapted to make electrical contact to terminals (941, 942) of the electronic component (191, 393).

5. The test device (300) according to any one of the claims 1 to 4, further comprising a reference microphone (355) for determining a value of an input sound.

6. The test device (300) according to any one of the claims 1 to 5, further comprising an inlet (580) being connected to a pressure generator (583).

7. The test device (300) according to any one of the claims 1 to 6, wherein the carrier (190) adapted to carry the plurality of the electronic components is a strip (590) comprising a substrate (593) wherein the substrate (593) forms the circular carrier section (711) and the carrier segment (611).

8. The test device (300) according to any one of the claims 1 to 6, wherein the carrier (190) adapted to carry the plurality of the electronic components is a clamping carrier (490) comprising multiple layers (491, 492, 493, 494) and wherein the clamping carrier (490) forms the circular carrier section (711) and the carrier segment (611).

9. A test system (100) for testing electronic components under variable pressure conditions wherein the test system (100) comprises a plurality of test devices (300) according to claims 1 to 8.

10. The test system (100) according to claim 9, comprising two groups of first gaskets (311) and second gaskets (316) wherein at least one of the groups is integrally formed from one gasket plate (410).

11. The test system (100) according to claim 9 or 10 further comprising a pressing device (141, 142, 141', 142'; 151,152) wherein the pressing device is adapted to press a board unit (110) and a pressure unit (120) against each other.

12. A method of testing an electronic component (191) under variable pressure conditions, wherein the method comprises:
providing a test device (300) comprising a first chamber half (313), a second chamber half (318), a first gasket (311), a second gasket (316), a carrier (190) adapted to carry a plurality of electronic components, wherein the carrier (190) comprises a carrier segment (611) and a circular carrier section (711), wherein the circular carrier section (711) denotes a region of the carrier which is defined by a closed line having a non neglectable width, wherein the circular carrier section (711) surrounds the carrier segment (611) and wherein the carrier segment (611) is adapted to carry a subgroup of the plurality of electronic components, wherein the circular carrier section (711) comprises a first side (713) and a second side (718),
forming an airtight seal by placing the first gasket (311) between the first chamber half (311) and the first side (713) of the circular carrier section (711) and
forming an airtight seal by placing the second gasket (316) between the second chamber half (318) and the second side (718) of the circular carrier section (711);
**characterised in that**, said test device comprising
a membrane (350) for generating a sound output.

## Patentansprüche

1. Testvorrichtung (300) zum Testen einer elektronischen Komponente (191) unter variablen Druckbedingungen, welche aufweist:
eine erste Kammerhälfte (313) und eine zweite Kammerhälfte (318),
einen ersten Dichtring (311) und einen zweiten Dichtring (316),
einen Carrier (190), welcher eingerichtet ist, eine Mehrzahl von elektronischen Komponenten zu tragen,
wobei der Carrier (190) ein Carriersegment (611) und einen ringförmigen Carrierabschnitt (711) aufweist,
wobei der ringförmige Carrierabschnitt (711) eine Region des Carriers bezeichnet, die mittels einer geschlossenen Linie definiert ist, welche eine nicht vernachlässigbare Breite hat,
wobei der ringförmige Carrierabschnitt (711) das Carriersegment (611) umgibt und wobei das Carriersegment (611) eingerichtet ist, eine Untergruppe der Mehrzahl der elektronischen Komponenten zu tragen,
wobei der ringförmige Carrierabschnitt (711) eine erste Seite (713) und eine zweite Seite (718) aufweist,
wobei der erste Dichtring (311) zwischen der ersten Kammerhälfte (313) und der ersten Seite (713) des ringförmigen Carrierabschnitts (711) platziert ist, um eine luftdichte Dichtung zu bilden, und
wobei der zweite Dichtring (316) zwischen der zweiten Kammerhälfte (318) und der zweiten Seite (718) des ringförmigen Carrierabschnitts (711) platziert ist, um eine luftdichte Dichtung zu bilden;
**dadurch gekennzeichnet, dass** die Testvorrichtung eine Membran (350) zum Erzeugen einer Geräuschausgabe aufweist.

2. Testvorrichtung (300) gemäß Anspruch 1, ferner aufweisend ein Durchgangsloch (331, 332, 431, 432, 433, 533, 731, 931) durch das Carriersegment (611),
wobei das Durchgangsloch als ein bidirektionaler Durchgang für Gasfluss zwischen einer ersten Kavitätenhälfte (314) und einer zweiten Kavitätenhälfte (319) fungiert.

3. Testvorrichtung (300) gemäß Anspruch 1 oder 2, wobei der ringförmige Carrierabschnitt (711) ein luftdichter Wandabschnitt (715) des Carriers (190) ist.

4. Testvorrichtung (300) gemäß einem beliebigen der Ansprüche 1 bis 3, ferner aufweisend einen Prüfsockel (340), welcher eingerichtet ist, um elektrischen Kontakt zu Terminals (941, 942) der elektronischen Komponente (191, 393) herzustellen.

5. Testvorrichtung (300) gemäß einem beliebigen der Ansprüche 1 bis 4, ferner aufweisend ein Referenzmikrofon (355) zum Bestimmen eines Werts eines Eingabegeräuschs.

6. Testvorrichtung (300) gemäß einem beliebigen der Ansprüche 1 bis 5, ferner aufweisend einen Eingang (580), welcher an einen Druckgenerator (583) verbunden ist.

7. Testvorrichtung (300) gemäß einem beliebigen der Ansprüche 1 bis 6, wobei der Carrier (190), welcher eingerichtet ist, die Mehrzahl der elektronischen Komponenten zu tragen, ein Streifen (590) ist, welcher ein Substrat (593) aufweist, wobei das Substrat (593) den ringförmigen Carrierabschnitt (711) und das Carriersegment (611) bildet.

8. Testvorrichtung (300) gemäß einem beliebigen der Ansprüche 1 bis 6, wobei der Carrier (190), welcher eingerichtet ist, die Mehrzahl der elektronischen Komponenten zu tragen, ein Klemmcarrier (490) ist, welcher mehrere Schichten (491, 492, 493, 494) aufweist, und wobei der Klemmcarrier (490) den ringförmigen Carrierabschnitt (711) und das Carriersegment (611) bildet.

9. Testsystem (100) zum Testen elektronischer Komponenten unter variablen Druckbedingungen, wobei das Testsystem (100) eine Mehrzahl von Testvorrichtungen (300) gemäß den Ansprüchen 1 bis 8 aufweist.

10. Testsystem (100) gemäß Anspruch 9, welches zwei Gruppen von ersten Dichtringen (311) und zweiten Dichtringen (316) aufweist, wobei zumindest eine der Gruppen integral aus einer Dichtringplatte (410) gebildet ist.

11. Testsystem (100) gemäß Anspruch 9 oder 10 ferner aufweisend eine Druckvorrichtung (141, 142, 141', 142'; 151, 152), wobei die Druckvorrichtung eingerichtet ist, eine Boardeinheit (110) und eine Druckeinheit (120) gegeneinander zu drücken.

12. Verfahren zum Testen einer elektronischen Komponente (191) unter variablen Druckbedingungen, wobei die Methode aufweist:
Bereitstellen einer Testvorrichtung (300) aufweisend eine erste Kammerhälfte (313), eine zweite Kammerhälfte (318), einen ersten Dichtring (311), einen zweiten Dichtring (316), einen Carrier (190), welcher eingerichtet ist, eine Mehrzahl von elektronischen Komponenten zu tragen, wobei der Carrier (190) ein Carriersegment (611) und einen ringförmigen Carrierabschnitt (711) aufweist, wobei der ringförmige Carrierabschnitt (711) eine Region des Carriers bezeichnet, die mittels einer geschlossenen Linie definiert ist, welche einen nicht vernachlässigbare Breite hat, wobei der ringförmige Carrierabschnitt (711) das Carriersegment (611) umgibt und wobei das Carriersegment (611) eingerichtet ist, eine Untergruppe der Mehrzahl von elektronischen Komponenten zu tragen, wobei der ringförmige Carrierabschnitt (711) eine erste Seite (713) und eine zweite Seite (718) aufweist,
Bilden einer luftdichten Dichtung mittels Platzierens des ersten Dichtrings (311) zwischen die erste Kammerhälfte (311) und die erste Seite (713) des ringförmigen Carrierabschnitts (711) und
Bilden einer luftdichten Dichtung mittels Platzierens des zweiten Dichtrings (316) zwischen die zweite Kammerhälfte (318) und die zweite Seite (718) des ringförmigen Carrierabschnitts (711);
**dadurch gekennzeichnet, dass** die Testvorrichtung eine Membran (350) zum Erzeugen einer Geräuschausgabe aufweist.

## Revendications

1. Dispositif de test (300) pour tester un composant électronique (191) dans des conditions de pression variable, comprenant :
une première moitié de chambre (313) et une deuxième moitié de chambre (318),
un premier joint (311) et un deuxième joint (316),
un support (190) apte à porter une pluralité de composants électroniques,
dans lequel le support (190) comprend un segment de support (611) et une section de support circulaire (711),
dans lequel la section de support circulaire (711) constitue une région du support qui est définie par une ligne fermée ayant une largeur non négligeable,
dans lequel la section de support circulaire (711) entoure le segment de support (611) et dans lequel le segment de support (611) est apte à porter un sous-groupe de la pluralité de composants électroniques,
dans lequel la section de support circulaire (711) comprend un premier côté (713) et un deuxième côté (718),
dans lequel le premier joint (311) est placé entre la première moitié de chambre (313) et le premier côté (713) de la section de support circulaire (711) pour former une étanchéité à l'air et
dans lequel le deuxième joint (316) est placé entre la deuxième moitié de chambre (318) et le deuxième côté (718) de la section de support circulaire (711) pour former une étanchéité à l'air ;
**caractérisé en ce que** ledit dispositif de test comprend une membrane (350) pour générer une sortie sonore.

2. Dispositif de test (300) selon la revendication 1, comprenant en outre un trou traversant (331, 332, 431, 432, 433, 533, 731, 931) à travers le segment de support (611),
dans lequel le trou traversant fonctionne comme un passage bidirectionnel pour un écoulement de gaz entre une première moitié de cavité (314) et une deuxième moitié de cavité (319).

3. Dispositif de test (300) selon la revendication 1 ou 2, dans lequel la section de support circulaire (711) est une section de paroi étanche à l'air (715) du support (190).

4. Dispositif de test (300) selon l'une quelconque des revendications 1 à 3, comprenant en outre une prise de test (340) apte à établir un contact électrique avec des bornes (941, 942) du composant électronique (191, 393) .

5. Dispositif de test (300) selon l'une quelconque des revendications 1 à 4, comprenant en outre un microphone de référence (355) pour déterminer une valeur d'un son d'entrée.

6. Dispositif de test (300) selon l'une quelconque des revendications 1 à 5, comprenant en outre une entrée (580) reliée à un générateur de pression (583).

7. Dispositif de test (300) selon l'une quelconque des revendications 1 à 6, dans lequel le support (190) apte à porter la pluralité de composants électroniques est une bande (590) comprenant un substrat (593), dans lequel le substrat (593) forme la section de support circulaire (711) et le segment de support (611).

8. Dispositif de test (300) selon l'une quelconque des revendications 1 à 6, dans lequel le support (190) apte à porter la pluralité de composants électroniques est un support de serrage (490) comprenant plusieurs couches (491, 492, 493, 494) et dans lequel le support de serrage (490) forme la section de support circulaire (711) et le segment de support (611).

9. Système de test (100) pour tester des composants électroniques dans des conditions de pression variable, dans lequel le système de test (100) comprend une pluralité de dispositifs de test (300) selon les revendications 1 à 8.

10. Système de test (100) selon la revendication 9, comprenant deux groupes de premiers joints (311) et de deuxièmes joints (316), dans lequel au moins l'un des groupes fait partie intégrante d'une plaque de joint (410).

11. Système de test (100) selon la revendication 9 ou 10, comprenant en outre un dispositif de pression (141, 142, 141', 142' ; 151, 152), dans lequel le dispositif de pression est apte à presser une unité de carte (110) et une unité de pression (120) l'une contre l'autre.

12. Procédé de test d'un composant électronique (191) dans des conditions de pression variable, dans lequel le procédé comprend :
la fourniture d'un dispositif de test (300) comprenant une première moitié de chambre (313), une deuxième moitié de chambre (318), un premier joint (311), un deuxième joint (316), un support (190) apte à porter une pluralité de composants électroniques, dans lequel le support (190) comprend un segment de support (611) et une section de support circulaire (711), dans lequel la section de support circulaire (711) constitue une région du support qui est définie par une ligne fermée ayant une largeur non négligeable, dans lequel la section de support circulaire (711) entoure le segment de support (611) et dans lequel le segment de support (611) est apte à porter un sous-groupe de la pluralité de composants électroniques, dans lequel la section de support circulaire (711) comprend un premier côté (713) et un deuxième côté (718),
la formation d'une étanchéité à l'air en plaçant le premier joint (311) entre la première moitié de chambre (311) et le premier côté (713) de la section de support circulaire (711) et
la formation d'une étanchéité à l'air en plaçant le deuxième joint (316) entre la deuxième moitié de chambre (318) et le deuxième côté (718) de la section de support circulaire (711) ;
**caractérisé en ce que** ledit dispositif de test comprend une membrane (350) pour générer une sortie sonore.
